# EUROPEAN PATENT APPLICATION

(11) **EP 2 463 402 A1**
(43) Date of publication of application: **13.06.2012**
(21) Application number: 10806470.0
(22) Date of filing: 04.08.2010
(51) Int. Cl.: C23C 14/56, C23C 16/54, H01L 31/04

(54) **APPARATUS FOR PRODUCING A THIN-FILM LAMINATION**

(30) Priority: 06.08.2009 JP 2009183315
(71) Applicant: Fuji Electric Co., Ltd., Kawasaki-shi Kanagawa 210-9530 (JP)
(72) Inventor: NISHIZAWA, Masanori, Kawasaki-shi Kanagawa 210-0856 (JP); YOKOYAMA, Shoji, Kawasaki-shi Kanagawa 210-0856 (JP); YAMADA, Takanori, Kawasaki-shi Kanagawa 210-0856 (JP)
(74) Representative: Appelt, Christian W.
(86) International application number: PCT/JP2010/063151
(87) International publication number: WO 2011/016471

(57) **Abstract**

Disclosed is an apparatus for manufacturing a thin-film laminate capable of preventing loosening of a strip-shaped flexible substrate at the time of conveying or misalignment of the strip-shaped flexible substrate with respect to a winding roller at the time of winding. In an apparatus for manufacturing a thin-film laminate, a strip-shaped flexible substrate is conveyed in a lateral direction in a state where the width direction of the strip-shaped flexible substrate wound in a roll shape is in a longitudinal posture, a deposition chamber is provided in the conveying direction of the strip-shaped flexible substrate, the strip-shaped flexible substrate is conveyed to the deposition chamber, a thin film is formed on the strip-shaped flexible substrate by a deposition device provided in the deposition chamber, and a thin-film laminate is wound in a roll shape. An adjustment roller 9 is provided in front of a winding device 4 which winds a thin-film laminate 1A in a roll shape, and a pair of grip rollers 7 and 8 are arranged in front of the adjustment roller 9 to convey the thin-film laminate 1A with at least the upper end of the thin-film laminate 1A sandwiched therebetween while maintaining a given height.

## Description

### TECHNICAL FIELD

The present invention relates to an apparatus for manufacturing a thin-film laminate in which a film-like flexible substrate is conveyed in a lateral direction in a state where the width direction of the flexible substrate is in a longitudinal posture, and plasma discharge by a high-frequency power supply is generated in a gas atmosphere within a vacuum chamber to form a thin film, and which has a mechanism suppressing local wrinkles, such as tensional wrinkles or compressive wrinkles, and loosening when conveying a thin-film laminate is conveyed, and a mechanism suppressing winding misalignment when winding the thin-film laminate.

### BACKGROUND ART

As a substrate of a thin-film laminate having a semiconductor thin film or the like, a substrate having high rigidity is usually used. Meanwhile, as a substrate for a photoelectric conversion element which is used for, for example, a solar cell or the like, from the viewpoint of lightweight, convenience, such as ease of treatment, and reduction in cost through mass production, a flexible substrate, such as resin, is used.

As an apparatus for manufacturing a thin-film laminate using a flexible substrate, a deposition device has been developed in which a strip-shaped flexible substrate passes through a plurality of deposition chambers arranged in series, a film is formed on the flexible substrate being stopped in each deposition chamber, an operation is repeatedly performed to convey the flexible substrate to the position of the next deposition chamber, and thin films having a plurality of different properties are laminated on the flexible substrate.

In this deposition device, the flexible substrate may be conveyed in the horizontal direction in a state where the width direction of the strip-shaped flexible substrate is maintained in the horizontal direction, and film formation may be carried out. Alternatively, the flexible substrate may be conveyed in the horizontal direction in a state where the width direction of the strip-shaped flexible substrate is maintained in the vertical direction, and film formation may be carried out. In the latter case, it is advantageous in that the surface of the flexible substrate is not easily contaminated, compared to the former case. However, if the number of deposition chambers increases, wrinkles occur in the surface of the flexible substrate due to stretch caused by gravity or the weight of the flexible substrate, and the flexible substrate meanders in the width direction or sags downward.

In order to solve these problems, a technique has been suggested in which an intermediate chamber is arranged between two central deposition chambers from among a plurality of deposition chambers, and an edge position control (EPC) roller is provided in the intermediate chamber to be in contact with the surface of the flexible substrate over the entire surface of the flexible substrate in the width direction. The EPC roller is described in Japanese Patent Application Laid-Open No. 2009-46285 (Patent Literature 1).
However, since film formation is usually carried out at a comparatively high temperature, if the EPC roller made of stainless steel is arranged between the deposition chambers, the flexible substrate is rapidly cooled, causing wrinkles or the like.
In order to prevent winding misalignment of the winding roller, it is preferable to use the EPC roller, but in the EPC roller, the balance of tension applied to the flexible substrate is collapsed, such that bending wrinkles easily occur. Usually, the EPC roller is expensive compared to a conveying roller.

Accordingly, a deposition device has been developed in which a plurality of sets of grip rollers are provided between a plurality of deposition chambers to sandwich the upper end of the strip-shaped flexible substrate in the vertical direction therebetween, and a plurality of sets of grip rollers are provided such that the rotation direction of each roller is inclined upward with respect to the conveying direction of the strip-shaped flexible substrate (see Patent Literature 2).
As described above, at least a set of grip rollers are arranged between a plurality of deposition chambers to sandwich the upper end of the strip-shaped flexible substrate in the vertical direction therebetween, and a plurality of sets of grip rollers at the upper end in the vertical direction are provided such that the rotation direction of each roller is inclined upward with respect to the conveying direction of the strip-shaped flexible substrate. Thus, when the strip-shaped flexible substrate is conveyed in the horizontal direction, a force which lifts the flexible substrate upward is generated. Therefore, even when the strip-shaped flexible substrate is conveyed over a long distance between a plurality of deposition chambers, it is possible to prevent the occurrence of wrinkles in the flexible substrate, meandering of the flexible substrate in the width direction, and downward sagging of the flexible substrate. It is also possible to maintain the position of the strip-shaped flexible substrate in the vertical direction with high precision.

### CITATION LIST

### PATENT LITERATURE

Patent Literature 1: Japanese Patent Application Laid-Open No. 2009-46285
Patent Literature 2: Japanese Patent Application Laid-Open No. 2009-38276

### DISCLOSURE OF INVENTION

### PROBLEM TO BE SOLVED BY THE INVENTION

Finally, when the strip-shaped flexible substrate having thin films formed thereon, that is, the thin-film laminate is wound by the winding roller, since the winding roller has a very high binding force, in order to control the height of the strip-shaped flexible substrate with the grip rollers, it is necessary that there is a distance between the winding roller and the grip rollers. If there is a distance, however, loosening occurs in the strip-shaped flexible substrate, that is, the thin-film laminate. If the position of the thin-film laminate is lowered, misalignment occurs when the thin-film laminate is wound around the winding roller, such that uniform winding is not carried out.

An object of the invention is to provide an apparatus for manufacturing a thin-film laminate capable of preventing loosening of a strip-shaped flexible substrate at the time of conveying or misalignment of the strip-shaped flexible substrate with respect to a winding roller at the time of winding.

### MEANS FOR SOLVING PROBLEM

In order to solve the above-described problems, the invention provides an apparatus for manufacturing a thin-film laminate in which a strip-shaped flexible substrate is conveyed in a lateral direction in a state where the width direction of the strip-shaped flexible substrate wound in a roll shape is in a longitudinal posture, a deposition chamber is provided in the conveying direction of the strip-shaped flexible substrate, the strip-shaped flexible substrate is conveyed to the deposition chamber, a thin film is formed on the strip-shaped flexible substrate by a deposition device provided in the deposition chamber, and a thin-film laminate is wound in a roll shape, an adjustment roller is provided in front of a winding device, which winds the thin-film laminate in a roll shape, to prevent loosening of the strip-shaped flexible substrate between grip rollers and the winding device and to suppress a change in an embracing angle and an influence on the conveying track of the strip-shaped flexible substrate due to an increase in the diameter of the winding roller at the time of winding, and a pair of grip rollers are arranged in front of the adjustment roller to convey the thin-film laminate with the upper end of the thin-film laminate sandwiched therebetween while maintaining a given height.
A detection device may be provided to detect the entering angle of the thin-film laminate with respect to the adjustment roller, and at least one of the inclination angle and the compressive force of the grip rollers may be controlled on the basis of detected data of the detection device.
An LPC roller whose position is movable in the width direction of the strip-shaped flexible substrate may be used for the winding roller.
The invention also provides an apparatus for manufacturing a thin-film laminate in which a strip-shaped flexible substrate wound in a roll shape is conveyed in an up-down direction, a deposition chamber is provided in the conveying direction of the strip-shaped flexible substrate or a substrate treatment section is provided to serve as a treatment chamber in which patterning is carried out on the strip-shaped flexible substrate, the strip-shaped flexible substrate is conveyed to the substrate treatment section, in at least a part of the substrate treatment section, an up-down conveying system is provided in which a thin film is formed by a deposition device provided in the deposition chamber or patterning is carried out on the strip-shaped flexible substrate by a patterning device provided in the treatment chamber, and a thin-film laminate is wound in a roller shape such that the width direction of the strip-shaped flexible substrate is in either a lateral posture or a longitudinal posture, an adjustment roller is provided in front of a winding device, which winds the thin-film laminate in a roll shape, to prevent the occurrence of loosening of the strip-shaped flexible substrate between grip rollers and the winding device and to suppress a change in an embracing angle and an influence on the conveying track of the strip-shaped flexible substrate due to an increase in the diameter of the winding roller at the time of winding, and a pair of grip rollers are arranged in front of the adjustment roller to convey the thin-film laminate with at least one end of the thin-film laminate in the width direction sandwiched therebetween.
A detection device may be provided to detect the entering angle of the thin-film laminate with respect to the adjustment roller, and at least one of the inclination angle and the compressive force of the grip rollers may be controlled on the basis of detected data of the detection device.
An LPC roller whose position is movable in the width direction of the strip-shaped flexible substrate may be used for the winding roller.

### EFFECTS OF THE INVENTION

According to claim 1, since the adjustment roller is provided in front of the winding device, it is possible to prevent the occurrence of loosening of the strip-shaped flexible substrate between the grip rollers and the winding device, and to suppress a change in an embracing angle and an influence on the conveying track of the strip-shaped flexible substrate due to an increase in the diameter of the winding roller at the time of winding. With the combination of the grip rollers and the adjustment roller, a substitute structure for an EPC roller can be made. Since an inexpensive structure is made compared to the EPC roller, it is more cost efficient than the related art.
According to claim 2, it is possible to reduce the entering angle of the thin-film laminate to maintain the thin-film laminate at a reference position.
According to claim 3, since the LPC roller is used as the winding roller, it is possible to eliminate misalignment involved in winding of the thin-film laminate.
According to claim 4, since the adjustment roller is provided in front of the winding device, it is possible to prevent the occurrence of loosening of the strip-shaped flexible substrate between the grip rollers and the winding device, and to suppress a change in an embracing angle and an influence on the conveying track of the strip-shaped flexible substrate due to an increase in the diameter of the winding roller at the time of winding.
With the combination of the grip rollers and the adjustment roller, a substitute structure for an EPC roller can be made. Since an inexpensive structure is made compared to the EPC roller, it is more cost efficient than the related art.
According to claim 5, it is possible to reduce the entering angle of the thin-film laminate to maintain the thin-film laminate at a reference position.
According to claim 6, since the LPC roller is used as the winding roller, it is possible to eliminate misalignment involved in winding of the thin-film laminate.

### BRIEF DESCRIPTION OF THE DRAWINGS

Fig. 1 shows an apparatus for manufacturing a thin-film laminate according to an embodiment of the invention, and (a) is a front view and (b) is a sectional view taken along the line B-B of Fig. 1(a).
Fig. 2(a) is a partial enlarged view of Fig. 1(a) and (b) is a plan view of Fig. 2(a).
Fig. 3 shows another embodiment of the invention, and (a) is a front view and (b) is a front view of Fig. 3(a).
Fig. 4 shows an apparatus for manufacturing a thin-film laminate according to another embodiment of the invention in which a thin-film laminate is conveyed in an up-down direction, and (a) is a front view and (b) is a sectional view taken along the line C-C of Fig. 4(a).
Fig. 5(a) is a partial enlarged view of Fig. 4(a), and (b) is a left side view of Fig. 5(a).

### BEST MODE FOR CARRYING OUT THE INVENTION

Hereinafter, an apparatus for manufacturing a thin-film laminate according to an embodiment of the invention will be described in detail with reference to the drawings.

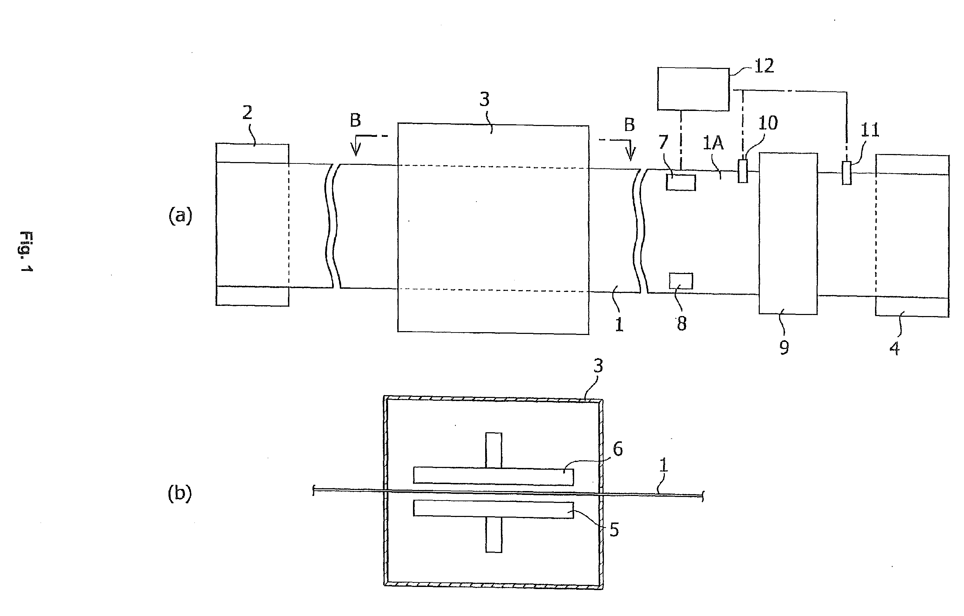

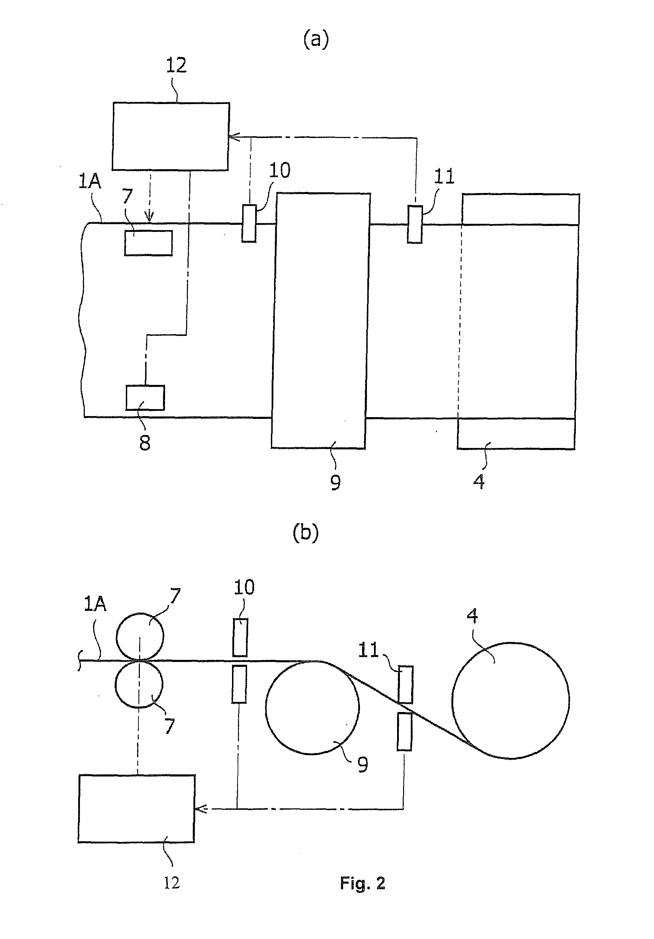

Figs. 1(a) and (b) show an embodiment of an apparatus for manufacturing a thin-film laminate. Figs. 2(a) and (b) show a winding device of Fig. 1(a) on a magnified scale.
Fig. 1(a) shows an unwinding roller 2 in which a strip-shaped flexible substrate 1 is wound in a roll shape, a deposition chamber 3 in which film formation is carried out on the strip-shaped flexible substrate 1, and a winding roller 4 to which a thin-film laminate 1A subjected to film formation in the deposition chamber 3 is conveyed and which winds the thin-film laminate 1A while maintaining at a given height.

In Figs. 1 and 2, the strip-shaped flexible substrate 1 is conveyed in the horizontal direction from the unwinding roller 2 in which the strip-shaped flexible substrate 1 is wound in a roll shape in a state where the width direction of the strip-shaped flexible substrate 1 is in the vertical direction, and is subjected to film formation by plasma discharge in the deposition chamber 3 in a gas atmosphere. The resultant thin-film laminate 1A is sequentially wound by the winding roller 4 serving as a winding device. The deposition chamber 3 is usually configured such that a high-frequency electrode 5 and a heater-embedded ground electrode 6 are arranged to face each other. Plasma discharge is generated in the gas atmosphere in a state where the deposition chamber 3 is in vacuum, and film formation is carried out on the flexible substrate 1 arranged between both electrodes 5 and 6.
The winding roller 4 is driven to rotate around a vertical shaft, and the roller diameter gradually increases as the thin-film laminate 1A is wound. On the upstream side of the winding roller 4, pairs of upper and lower grip rollers 7 and 8 are provided. The grip rollers 7 and 8 convey the thin-film laminate 1A while sandwiching the upper end and the lower end of the thin-film laminate 1A therebetween. As in this embodiment, when the flexible substrate is conveyed in a state where the width direction of the flexible substrate is in the longitudinal posture, the thin-film laminate 1A may be conveyed while only the upper end of the thin-film laminate 1A is sandwiched between the upper grip rollers 7.
An adjustment roller 9 having a given diameter is provided in front of the winding roller 4, that is, between the winding roller 4 and the grip rollers 7 and 8. The adjustment roller 9 applies tension to the thin-film laminate 1A while the thin-film laminate 1A is in contact therewith at a winding angle (embracing angle). The adjustment roller 9 feeds the thin-film laminate 1A to the winding roller 4 along a given track while applying tension to the thin-film laminate 1A. Specifically, as shown in Fig. 2(b), the thin-film laminate 1A is in contact with the adjustment roller 9 at a winding angle (embracing angle), such that the conveying direction to the winding roller 4 is changed and tension is generated by the winding roller 4.

The grip rollers 7 and 8 include a pair of upper grip rollers 7 which guide the thin-film laminate 1A being conveyed in a state where the width direction of the thin-film laminate 1A is in the vertical direction while sandwiching both sides on the upper side, that is, on one side of the thin-film laminate 1A therebetween, and a pair of lower grip rollers 8 which guide the thin-film laminate 1A while sandwiching both surfaces on the lower side, that is, on another side of the thin-film laminate 1. A pair of upper grip rollers 7 are driven to rotate in opposing directions around the vertical shafts thereof to convey the thin-film laminate 1A while sandwiching both surfaces on the upper side of the thin-film laminate 1, that is, on one side of the thin-film laminate 1A at a given pressure therebetween. Similarly to the upper grip rollers 7, a pair of lower grip roller 8 are driven to rotate in opposing directions around the vertical shafts thereof to convey the thin-film laminate 1A while sandwiching both surfaces on the lower side, that is, on another side of the thin-film laminate 1A at a given pressure therebetween.

Sensors 10 and 11 which detect the positions are respectively provided in front and at the rear of the adjustment roller 9. The sensors 10 and 11 are, for example, optical sensors or the like. The sensor 10 detects the entering angle of the thin-film laminate 1A with respect to the adjustment roller 9, and the sensor 11 detects the entering angle of the thin-film laminate 1A with respect to the winding roller 4. The compressive force of the grip rollers 7 and 8 is adjusted on the basis of the detection result of the entering angle. The sensors 10 and 11 detect, for example, the positions thereof with respect to the thin-film laminate 1A, thereby detecting the entering angle of the thin-film laminate 1A on the basis of a difference in the position.
The compressive force of the grip rollers 7 and 8 are controlled by a control device 12. The control device 12 calculates a necessary compressive force on the basis of the detection results from the sensors 10 and 11.

According to the above-described embodiment, the strip-shaped flexible substrate 1 which is conveyed in a state where the width direction of the strip-shaped flexible substrate 1 is in the vertical direction is subjected to film formation by plasma discharge in the deposition chamber 3, and fed as the thin-film laminate 1A while being sandwiched between the grip rollers 7 and 8. The thin-film laminate 1A passes through the adjustment roller 9 and is wound around the winding roller 4. At this time, the entering angle with respect to the adjustment roller 9 is detected by the sensors 10 and 11, and the detection results are sent to the control device 12, such that the compressive force of the grip rollers 7 and 8 provided in front of the adjustment roller 9 is adjusted. In this way, loosening or sagging of the thin-film laminate 1A is prevented, and the thin-film laminate 1A is wound around the winding roller 4 at a given height.

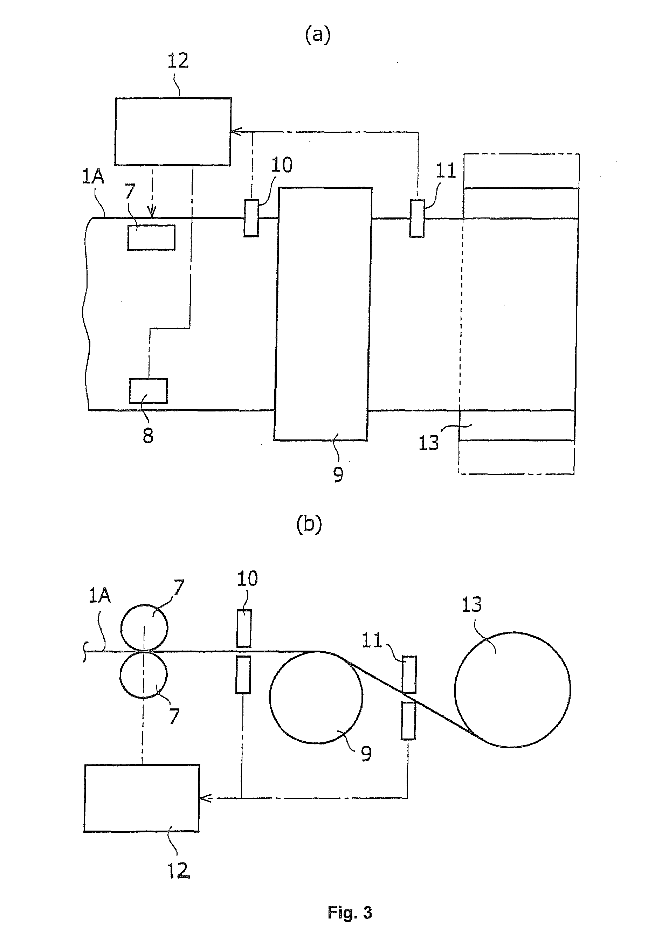

Figs. 3(a) and (b) are conceptual diagrams showing another embodiment of the invention. The same parts as those in Figs. 2(a) and (b) are represented by the same reference numerals, and description thereof will be omitted. In this case, since an LPC roller is used for the winding roller 13, the configuration and the actions of other devices are the same as those in of Figs. 2(a) and (b).

In this case, since an LPC roller is used for the winding roller 13, it is possible to change the winding roller 13 at the time of winding by moving up and down the winding roller 13, as indicated by a two-dot-chain line of the drawing. Thus, the height of the winding roller 13 is adjusted in accordance with the height at which the thin-film laminate 1A has been conveyed, thereby preventing winding misalignment of the thin-film laminate 1A in the winding roller 13. The height of the thin-film laminate 1A is controlled by the grip rollers 7 and 8, thereby controlling the occurrence of the entering angle of the thin-film laminate 1A with respect to the adjustment roller 9. The winding roller 13 can change the position thereof to correspond to the height of the thin-film laminate 1A by the sensor 11 provided between the adjustment roller 9 and the winding roller 13. A change in the height of the thin-film laminate 1A by the entering angle of the thin-film laminate 1A with respect to the adjustment roller 9 which cannot be suppressed by the grip rollers 7 and 8 can be measured by the sensor 10, and the height of the winding roller 13 can be adjusted. In this way, the control of the entering angle of the thin-film laminate 1A with respect to the adjustment roller 9 and the adjustment of the winding height in the winding roller 13 are performed simultaneously, thereby further improving the winding precision in the winding roller 13. With the use of the LPC roller as the winding roller 13, cost increases but is low compared to the EPC roller.

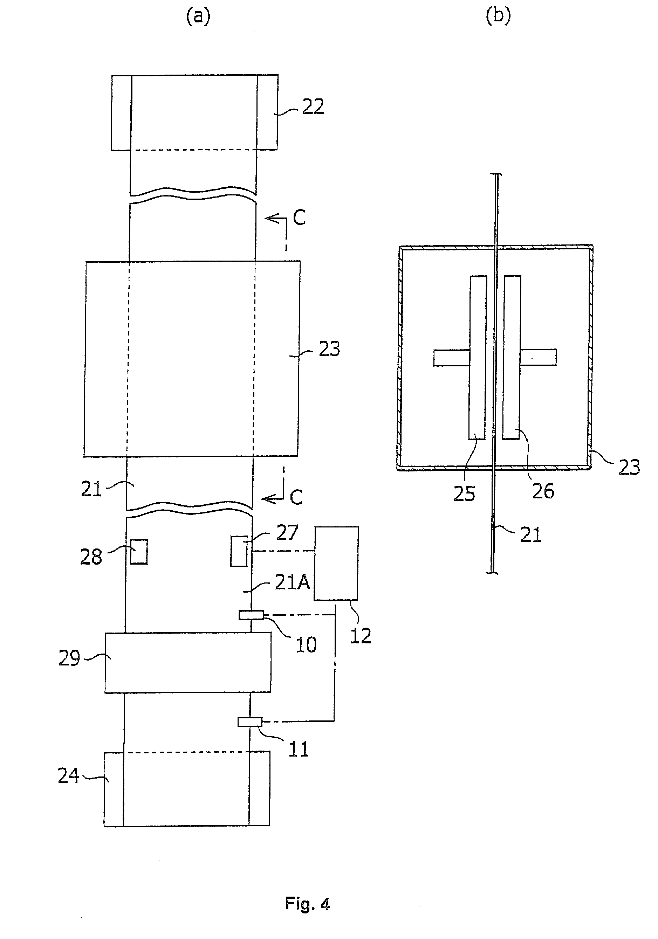

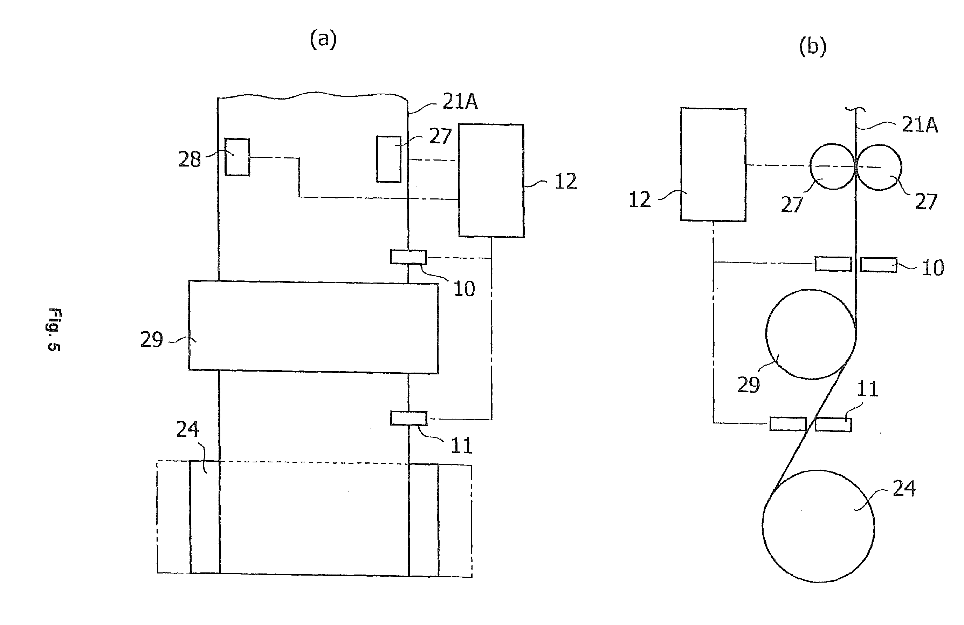

Figs. 4(a) and (b) show another embodiment of an apparatus for manufacturing a thin-film laminate in which a thin-film laminate is conveyed in the up-down direction. The same parts as those in Figs. 1(a) and (b) are represented by the same reference numerals. Figs. 5(a) and (b) show a winding device of Fig. 4(a) on a magnified scale.
Fig. 4(a) shows an unwinding roller 22 in which a strip-shaped flexible substrate 21 is wound in a roll shape such that the strip-shaped flexible substrate 21 is conveyed in the up-down direction, a substrate treatment section 23 serving as a deposition chamber in which film formation is carried out on the strip-shaped flexible substrate 21 or a treatment chamber in which pattering is carried out on the strip-shaped flexible substrate 21, and a winding roller 24 to which a thin-film laminate 21A subjected to film formation in the substrate treatment section 23 and which winds the thin-film laminate 21A.

In Figs. 4 and 5, the unwinding roller 22 in which the strip-shaped flexible substrate 21 is wound in a roll shape is arranged to convey the strip-shaped flexible substrate 21 in the up-down direction from ceiling to floor or from floor to ceiling in at least a part of the conveying course.
For example, a substrate treatment section 23 is arranged in halfway of the shaped flexible substrate 21 which is conveyed from ceiling to floor, and carries out film formation on the strip-shaped flexible substrate 21 by plasma discharge in the deposition chamber in a gas atmosphere or patterning on the strip-shaped flexible substrate 21 by a laser patterning device. The thin-film laminate 21A subjected to film formation by plasma discharge or laser patterning is sequentially wound by the winding roller 24 serving as a winding device arranged on the floor side. As in the above-described embodiment, the deposition chamber generates plasma discharge in a state where the deposition chamber 23 is in vacuum, and carries out film formation on the flexible substrate 21 arranged between both electrodes 25 and 26.
The winding roller 24 is driven to rotate around the axis of the thin-film laminate 21A in the width direction, and the roller diameter gradually increases as the thin-film laminate 21A is wound. On the upstream side of the winding roller 24, pairs of grip rollers 27 and 28 are provided in the width direction. The grip rollers 27 and 28 convey the thin-film laminate 21A while sandwiching the upper end and the lower end of the thin-film laminate 21A therebetween. An adjustment roller 29 having a given diameter is provided in front of the winding roller 24, that is, between the winding roller 24 and the grip rollers 27 and 28. The adjustment roller 29 can prevent the occurrence of loosening of the strip-shaped flexible substrate between the grip rollers and the winding device and can suppress a change in an embracing angle and an influence on the conveying track of the strip-shaped flexible substrate due to an increase in the diameter of the winding roller at the time of winding. The adjustment roller 29 feeds the thin-film laminate 21A to the winding roller 24 along a given track while applying tension to the thin-film laminate 21A.
Although in this embodiment, the unwinding roller 22 and the winding roller 24 are arranged such that the width direction of the strip-shaped flexible substrate 21 and the thin-film laminate 21A is in the horizontal direction with respect to the floor, the invention is not limited thereto. The unwinding roller 22 and the winding roller 24 may be arranged such that the width direction of the strip-shaped flexible substrate 21 and the thin-film laminate 21A is in the longitudinal posture, and the substrate treatment section 23 is conveyed in the up-down direction.
When the conveying posture of the strip-shaped flexible substrate 21 and the thin-film laminate 21A is the longitudinal posture, it should suffice that at least the upper grip rollers 27 are arranged. When the conveying direction is the up-down direction, it is necessary that both sides of the strip-shaped flexible substrate 21 and the thin-film laminate 21A in the width direction are sandwiched between the grip rollers 27 and 28.

The grip rollers 27 and 28 include a pair of one-side grip rollers 27 which guide the thin-film laminate 21A which is conveyed in the up-down direction in a state where the width direction is the lateral direction while sandwiching both surfaces on one side of the thin-film laminate 21A in the width direction therebetween, and a pair of another-side grip rollers 28 which guide the thin-film laminate 21A while sandwiching both surface on another side of the thin-film laminate 21A in the width direction therebetween. A pair of one-side grip rollers 27 are driven to rotate in opposing directions around the axis of the thin-film laminate 21A in the width direction, that is, the axis in the lateral direction to convey the thin-film laminate 21 while sandwiching both surface of one side of the thin-film laminate 21A at a given pressure therebetween. Similarly to the one-side grip rollers 27,
a pair of another-side grip rollers 28 are driven to rotate in opposing directions around the axis of the thin-film laminate 21A in the width direction to convey the thin-film laminate 21A while sandwiching both surfaces on another side of the thin-film laminate 21A in the width direction at a given pressure therebetween.

As in the embodiment of Fig. 1, sensors 10 and 11 which detect the positions are respectively in front and at the rear of the adjustment roller 29. The sensors 10 and 11 are, for example, optical sensor or the like, and detect the entering angle of the thin-film laminate 21A with respect to the adjustment roller 29. The compressive force of the grip rollers 27 and 28 is adjusted on the basis of the detection result of the entering angle. The sensors 10 and 11 detect, for example, the positions thereof with respect to the thin-film laminate 21A, thereby detecting the entering angle with respect to the thin-film laminate 21A on the basis of a difference in the position.
The compressive force of the grip rollers 27 and 28 is controlled by the control device 12. The control device 12 calculates a necessary compressive force on the basis of the detection results from the sensors 10 and 11.

According to the above-described embodiment, the strip-shaped flexible substrate 21 is conveyed in the up-down direction from ceiling to floor from the unwinding roller 22 in which the strip-shaped flexible substrate 21 is wound in a roll shape. The strip-shaped flexible substrate 21 which is conveyed from ceiling to floor is subjected to film formation by plasma discharge in the substrate treatment section 23, and fed as the thin-film laminate 21A while being sandwiched between the grip rollers 27 and 28. The thin-film laminate 21A passes through the adjustment roller 29 and is wound around the winding roller 24. At this time, the entering angle with respect to the adjustment roller 29 is detected by the sensors 10 and 11, and the detection results are sent to the control device 12, such that the compressive force of the grip rollers 27 and 28 provided in the front of the adjustment roller 29 is adjusted. In this way, loosening or sagging of the thin-film laminate 21A is prevented, and the thin-film laminate 21A is wound around the winding roller 24.
In the above-described embodiment, an LPC roller which has been described in the embodiment of Fig. 3 may be used as the winding roller 24.
In this case, with the use of the LPC roller as the winding roller 24, it is possible to change the position of the winding roller at the time of winding by moving up and down the winding roller, as indicated by a two-dot-chain line of the drawing. Therefore, it is possible to adjust the position of the thin-film laminate 21A in the width direction to prevent winding misalignment of the thin-film laminate 21A.

The invention is not limited to the above-described embodiments. For example, although in the embodiment of Fig. 1, the compressive force of the grip rollers 7 and 8 is adjusted to control the height of the thin-film laminate 1A, the rotation shafts of pairs of upper and lower grip rollers 7 and 8 may be inclined to adjust an inclination angle, thereby controlling the height of the thin-film laminate 1A. In this case, the inclination angle of a pair of upper grip rollers 7 is adjusted such that the thin-film laminate 1A is usually guided upward, thereby maintaining the height of the thin-film laminate 1A. A pair of lower grip rollers 8 are inclined to stretch downward with respect to the upper grip rollers 7 such that no wrinkles occur in the thin-film laminate 1A. Therefore, when the thin-film laminate 1A is still lowered, the inclination angle of the grip rollers 8 may be set such that a pair of lower grip rollers 8 are maintained horizontally. With regard to the grip rollers 7 and 8, the adjustment of the compressive force and the adjustment of the inclination angle may be used together.
Although in the above-described embodiments, the entering angle is detected by the sensors 10 and 11, the entering angle may be detected by other methods. Although in the above-described embodiment, unidirectional conveying has been described, the invention may be applied to bidirectional conveying. In this case, when the adjustment roller 9 or 29 and the grip rollers 7 and 8 or 27 and 28 are provided in the unwinding roller 2 or 22, the same effects can be obtained. The sensors 10 and 11 may be arranged with the adjustment roller 9 or 29 sandwiched therebetween. It should be noted that various changes may be made without departing from the gist of the invention.

## Claims

1. An apparatus for manufacturing a thin-film laminate,
wherein a strip-shaped flexible substrate is conveyed in a lateral direction in a state where the width direction of the strip-shaped flexible substrate wound in a roll shape is in a longitudinal posture,
a deposition chamber is provided in the conveying direction of the strip-shaped flexible substrate,
the strip-shaped flexible substrate is conveyed to the deposition chamber, a thin film is formed on the strip-shaped flexible substrate by a deposition device provided in the deposition chamber, and a thin-film laminate is wound in a roll shape,
an adjustment roller is provided in front of a winding device, which winds the thin-film laminate in a roll shape, to prevent the occurrence of loosening of the strip-shaped flexible substrate between grip rollers and the winding device and to suppress a change in an embracing angle and an influence on the conveying track of the strip-shaped flexible substrate due to an increase in the diameter of the winding roller at the time of winding, and
a pair of grip rollers are arranged in front of the adjustment roller to convey the thin-film laminate with the upper end of the thin-film laminate sandwiched therebetween while maintaining a given height.

2. The apparatus according to claim 1,
wherein a detection device is provided to detect the entering angle of the thin-film laminate with respect to the adjustment roller, and at least one of the inclination angle and the compressive force of the grip rollers is controlled on the basis of detected data of the detection device.

3. The apparatus according to claim 2,
wherein an LPC roller whose position is movable in the width direction of the strip-shaped flexible substrate is used for the winding roller.

4. An apparatus for manufacturing a thin-film laminate,
wherein a strip-shaped flexible substrate wound in a roll shape is conveyed in an up-down direction,
a deposition chamber is provided in the conveying direction of the strip-shaped flexible substrate or a substrate treatment section is provided to serve as a treatment chamber in which patterning is carried out on the strip-shaped flexible substrate,
the strip-shaped flexible substrate is conveyed to the substrate treatment section, in at least a part of the substrate treatment section, an up-down conveying system is provided in which a thin film is formed by a deposition device provided in the deposition chamber or patterning is carried out on the strip-shaped flexible substrate by a patterning device provided in the treatment chamber, and a thin-film laminate is wound in a roller shape such that the width direction of the strip-shaped flexible substrate is in either a lateral posture or a longitudinal posture,
an adjustment roller is provided in front of a winding device, which winds the thin-film laminate in a roll shape, to prevent the occurrence of loosening of the strip-shaped flexible substrate between grip rollers and the winding device and to suppress a change in an embracing angle and an influence on the conveying track of the strip-shaped flexible substrate due to an increase in the diameter of the winding roller at the time of winding, and
a pair of grip rollers are arranged in front of the adjustment roller to convey the thin-film laminate with at least one end of the thin-film laminate in the width direction sandwiched therebetween.

5. The apparatus according to claim 4,
wherein a detection device is provided to detect the entering angle of the thin-film laminate with respect to the adjustment roller, and at least one of the inclination angle and the compressive force of the grip rollers is controlled on the basis of detected data of the detection device.

6. The apparatus according to claim 5,
wherein an LPC roller whose position is movable in the width direction of the strip-shaped flexible substrate is used for the winding roller.
